# EUROPÄISCHE PATENTANMELDUNG

(11) **EP 4 450 940 A1**
(43) Veröffentlichungstag der Anmeldung: **23.10.2024**
(21) Anmeldenummer: 24163113.4
(22) Anmeldetag: 13.03.2024
(51) Int. Cl.: G01M 3/02, H02G 15/013

(54) **PRÜFADAPTER FÜR EINEN HOCHVOLTKABELSTRANG, PRÜFSYSTEM FÜR EINEN HOCHVOLTKABELSTRANG, SOWIE VERFAHREN ZUR HERSTELLUNG EINES PRÜFADAPTERS FÜR EINEN HOCHVOLTKABELSTRANG**

(30) Priorität: 03.04.2023 DE 102023108525
(71) Anmelder: Lisa Dräxlmaier GmbH, 84137 Vilsbiburg (DE)
(72) Erfinder: Schneider, Andreas, 84155 Bodenkirchen (DE); Mayer, Anton, 84137 Vilsbiburg (DE)

(57) **Zusammenfassung**

Prüfadapter (1) für einen Hochvoltkabelstrang (20), der Prüfadapter (1) umfassend: zumindest zwei elektrische Leiter (4), die jeweils dazu ausgebildet sind, ein Hochvoltleiter des Hochvoltkabelstrangs (20) mit einer elektrischen Prüfeinrichtung zu verbinden, zumindest einen Fluidkanal (7), der dazu ausgebildet ist, mit einer Dichtheitsprüfeinrichtung fluidkommunizierend verbunden zu werden, und einen Dichtkörper (3), wobei sich die elektrischen Leiter (4) und der Fluidkanal (7) derart durch den Dichtkörper (3) hindurch erstrecken, dass die elektrischen Leiter (4) und der Fluidkanal (7) durch den Dichtkörper (3) jeweils gegeneinander und in Bezug auf die Umgebung abgedichtet werden.

## Beschreibung

### Technisches Gebiet

Die vorliegende Erfindung betrifft einen Prüfadapter für einen Hochvoltkabelstrang. Der Prüfadapter umfasst zumindest zwei elektrische Leiter, einen Fluidkanal und einen Dichtkörper.

Ein Prüfsystem, das zumindest einen eingangs erwähnten Prüfadapter aufweist, ist ebenfalls Gegenstand der der vorliegenden Erfindung.

Ferner betrifft die vorliegende Erfindung ein Verfahren, dass die gleiche erfinderische Idee, wie der Prüfadapter verwirklicht. Das Verfahren betrifft insbesondere die Herstellung eines solchen Prüfadapters.

### Stand der Technik

Aufgrund diverser gesetzlicher und technischer Vorgaben ist es notwendig, dass Hochvoltsysteme, insbesondere Hochvoltkabelstränge, gegenüber der Umgebung fluiddicht sind und dass die einzelnen Hochvoltleiter in den Hochvoltkabelsträngen hinreichend gegeneinander geschirmt sind. Dies trifft insbesondere auf Hochvoltkabelstränge zu, die zur Verwendung in Fahrzeugen, insbesondere zur Verwendung in Kraftfahrzeugen, vorgesehen sind.

Dementsprechend werden die Hochvoltkabelstränge nach ihrer Herstellung einer elektrischen Prüfung, insbesondere einer Hochvoltprüfung, und einer Dichtheitsprüfung unterzogen. Im Stand der Technik werden die einzelnen Prüfungen nacheinander durchgeführt. Hierzu wird der Hochvoltkabelstrang beispielsweise zunächst mit einer elektrischen Prüfeinrichtung, insbesondere einer Hochvoltprüfeinrichtung, elektrisch verbunden, um den Hochvoltkabelstrang elektrisch zu prüfen. Zur Herstellung der elektrischen Verbindung muss der Hochvoltkabelstrang regelmäßig an einen elektrischen Prüfadapter der elektrischen Prüfeinrichtung angeschlossen werden. Nach der elektrischen Prüfung wird der Hochvoltkabelstrang von der elektrischen Prüfeinrichtung, insbesondere von dem elektrischen Prüfadapter, getrennt und mit einer Dichtheitsprüfeinrichtung, insbesondere einem Dichtheitsprüfadapter der Dichtheitsprüfeinrichtung, verbunden, um die Dichtheit des Hochvoltkabelstrangs zu prüfen.

Da die einzelnen Prüfschritte nacheinander erfolgen und der Hochvoltkabelstrang während des Prüfverfahrens manuell mit unterschiedlichen Prüfadaptern verbunden werden muss, ist das gesamte Prüfverfahren sehr langwierig. Darüber hinaus sind die bekannten Prüfverfahren aufgrund der Vielzahl der benötigten Prüfadapter relativ kostenintensiv.

### Beschreibung der Erfindung

Ausgehend von dem oben aufgeführten Stand der Technik ist es eine Aufgabe der vorliegenden Erfindung, eine Vorrichtung anzugeben, welche die oben genannten Probleme und Nachteile des Standes der Technik ausräumt. Insbesondere ist es eine Aufgabe der vorliegenden Erfindung, eine Vorrichtung für einen Hochvoltkabelstrang anzugeben, die kostengünstig herstellbar ist und mit der die Gesamtdauer der Prüfverfahren für Hochvoltkabelstränge reduziert werden kann.

Diese Aufgabe wird mit einem Prüfadapter gemäß Anspruch 1 und/oder einem Prüfsystem gemäß Anspruch 7 gelöst. Vorteilhafte Weiterbildungen und Ausführungsformen des Prüfadapters und des Prüfsystems sind Gegenstand der abhängigen Ansprüche und/oder werden in der nachfolgenden Beschreibung erläutert.

Die erfindungsgemäße Lösung umfasst einen Prüfadapter, der zumindest zwei elektrische Leiter, zumindest einen Fluidkanal und einen Dichtkörper aufweist. Der Prüfadapter ist vorzugsweise dazu ausgebildet, mit einem Hochvoltkabelstrang verbunden zu werden. Alternativ oder zusätzlich kann der Prüfadapter dazu geeignet sein, im Rahmen einer elektrischen Prüfung und einer Dichtheitsprüfung des Hochvoltkabelstrangs verwendet zu werden. Beispielsweise kann der Prüfadapter zwischen dem Hochvoltkabelstrang und einer elektrischen Prüfeinrichtung, insbesondere einer Hochvoltprüfeinrichtung, sowie einer Dichtheitsprüfeinrichtung anordenbar und/oder angeordnet sein. Bevorzugt verbindet der Prüfadapter den Hochvoltkabelstrang, insbesondere ein Hochvoltsteckergehäuse des Hochvoltkabelstrangs, mit der elektrischen Prüfeinrichtung und der Dichtheitsprüfeinrichtung.

Erfindungsgemäß sind die elektrischen Leiter jeweils dazu ausgebildet, einen Hochvoltleiter des Hochvoltkabelstrangs mit der elektrischen Prüfeinrichtung zu verbinden. Beispielsweise kann zumindest einer der elektrischen Leiter einen elektrischen Federkontaktstift aufweisen. Mit dem elektrischen Federkontaktstift kann ein Hochvoltleiter des Hochvoltkabelstrangs, insbesondere ein Steckerkontakt des Hochvoltkabelstrangs, elektrisch kontaktiert werden.

Der Fluidkanal ist erfindungsgemäß dazu ausgebildet, mit der Dichtheitsprüfeinrichtung fluidkommunizierend verbunden zu werden. Das heißt, dass ein Fluid von der Dichtheitsprüfeinrichtung in den Fluidkanal strömen kann und/oder von dem Fluidkanal in die Dichtheitsprüfeinrichtung strömen kann. An einem von der Dichtheitsprüfeinrichtung abgewandten Ende des Fluidkanals kann der Fluidkanal eine Mündungsöffnung aufweisen. Über die Mündungsöffnung kann das Fluid aus dem Fluidkanal ausströmen und/oder in den Fluidkanal einströmen. Vorzugsweise ist die Mündungsöffnung dem Hochvoltkabelstrang, insbesondere dem Hochvoltsteckergehäuse des Hochvoltkabelstrangs, zugewandt. Bei dem Fluid kann es sich um ein Gas, insbesondere um Druckluft, handeln.

Der Dichtkörper des Prüfadapters ist erfindungsgemäß derart ausgebildet und/oder angeordnet, dass sich die elektrischen Leiter und der Fluidkanal durch den Dichtkörper hindurch erstrecken. Dabei werden die elektrischen Leiter und der Fluidkanal durch den Dichtkörper gegeneinander und in Bezug auf die Umgebung abgedichtet. Vorzugsweise werden die elektrischen Leiter und der Fluidkanal jeweils durch den Dichtkörper voneinander beabstandet. Beispielsweise kann der Dichtkörper jeden elektrischen Leiter und den Fluidkanal derart umhüllen, dass keiner der elektrischen Leiter den jeweils anderen elektrischen Leiter und/oder den Fluidkanal berührt. Mit anderen Worten kann der Dichtkörper die elektrischen Leiter und den Fluidkanal jeweils ummanteln, zumindest abschnittsweise ummanteln. Die elektrischen Leiter und der Fluidkanal können in dem Dichtkörper eingefasst sein.

Der erfindungsgemäße Prüfadapter bewirkt vorteilhafterweise, dass sowohl ein Anschluss für die Dichtheitsprüfung, nämlich der Fluidkanal, und Anschlüsse für die elektrische Prüfung, nämlich die zumindest zwei elektrischen Leiter, bereitgestellt werden. Darüber hinaus bewirkt der Dichtkörper, dass die elektrischen Leiter und der Fluidkanal gegeneinander und in Bezug auf die Umgebung abgedichtet sind. Dies hat zur Folge, dass die elektrischen Leiter das Ergebnis der Dichtheitsprüfung nicht negativ beeinflussen und das der Prüfadapter insgesamt eine hinreichende Dichtigkeit aufweist. Der erfindungsgemäße Prüfadapter hat daher den Vorteil, dass die elektrische Prüfung und die Dichtheitsprüfung aufgrund des Prüfadapters parallel bzw. zeitgleich erfolgen können, ohne dass das Ergebnis der jeweiligen Prüfung von der anderen Prüfung negativ beeinflusst wird. Dementsprechend kann die Dauer des gesamten Prüfungsverfahrens durch den erfindungsgemäßen Prüfadapter reduziert werden. Davon unabhängig verfügt der erfindungsgemäße Prüfadapter auch nur über eine geringe Anzahl an Bauteilen. Dies reduziert die Herstellungskosten des Prüfadapters erheblich.

Bei einer beispielhaften Weiterbildung umfasst der Prüfadapter ein Koppelelement. Vorzugsweise ist das Koppelelement dazu ausgebildet, mit dem Hochvoltkabelstrang, insbesondere dem Hochvoltsteckergehäuse des Hochvoltkabelstrangs, verbunden zu werden. Beispielsweise kann das Koppelelement zwischen dem Dichtkörper und dem Hochvoltkabelstrang, insbesondere dem Hochvoltsteckergehäuse des Hochvoltkabelstrangs, anordenbar und/oder angeordnet sein. Das Koppelelement weist bevorzugt eine Dichtseite und eine Anschlussseite auf. Die Anschlussseite ist vorteilhafterweise der Dichtseite gegenüberliegend angeordnet.

Die Dichtseite kann eine dem Dichtkörper zugewandte Seite des Koppelelements sein. Vorzugsweise ist das Koppelelement über die Dichtseite mit dem Dichtkörper verbunden. Besonders bevorzugt ist das Koppelelement unmittelbar über die Dichtseite mit dem Dichtkörper verbunden. Das heißt, dass zwischen der Dichtseite des Koppelelements und dem Dichtkörper keine weitere Schicht, wie beispielsweise eine Klebstoffschicht, vorgesehen werden muss. Der Dichtkörper kann an die Dichtseite des Koppelelements angegossen sein.

Die Anschlussseite des Koppelelements kann eine vom Dichtkörper abgewandte Seite des Koppelelements sein. Vorzugsweise ist das Koppelelement über die Anschlussseite mit dem Hochvoltkabelstrang, insbesondere dem Hochvoltsteckergehäuse des Hochvoltkabelstrangs, verbindbar, vorzugsweise abdichtend - also fluiddicht - verbindbar.

Die Weiterbildung mit einem Koppelelement kann vorteilhafterweise bewirken, dass der Prüfadapter besonders gut mit dem zu prüfenden Hochvoltkabelstrang verbunden werden kann.

Das Koppelelement kann einstückig ausgebildet sein. Beispielsweise kann das Koppelelement ein Frästeil, insbesondere ein einstückiges Frästeil, sein. Alternativ kann das Koppelelement ein Spritzgussbauteil sein, das im Rahmen eines Spritzgussverfahrens, insbesondere innerhalb eines einzigen Spritzvorgangs, hergestellt ist.

Alternativ oder zusätzlich kann das Koppelelement mit einem Prüfadaptergehäuse verbindbar sein. Bevorzugt ist die Verbindung zwischen dem Koppelelement und dem Prüfadaptergehäuse lösbar. Das heißt, dass das Koppelelement zerstörungsfrei vom Prüfadapter entfernt werden kann. Beispielsweise ist das Koppelelement kraftschlüssig, insbesondere über eine Schraubverbindung, mit dem Prüfadaptergehäuse verbindbar.

Derartige Ausführungsformen des Koppelelements bewirken vorteilhafterweise, dass der Prüfadapter besonders kostengünstig hergestellt werden kann.

Vorzugsweise erstrecken sich die zumindest zwei elektrischen Leiter durch das Koppelelement hindurch und/oder ragen zumindest in das Koppelelement hinein. Beispielsweise kann der elektrische Leiter vom Dichtkörper, über die Dichtseite des Koppelelements, in das Koppelelement hineinragen. Auf der Anschlussseite kann der elektrische Leiter aus dem Koppelelement herausragen. Beispielsweise kann der elektrische Leiter mit seinem elektrischen Federkontaktstift auf der Anschlussseite des Koppelelements aus dem Koppelelement herausragen. Bevorzugt kontaktiert der elektrische Leiter den Hochvoltleiter des Hochvoltkabelstrangs auf der Anschlussseite des Koppelelements.

Solch eine beispielhafte Ausführungsform des Koppelelements kann vorteilhafterweise bewirken, dass mittels des Prüfadapters die elektrische Prüfung zuverlässig durchgeführt werden kann, selbst wenn zeitgleich eine Dichtheitsprüfung ausgeführt wird. Dies hat den Vorteil, dass durch den Prüfadapter die Gesamtprüfdauer für den Hochvoltkabelstrang reduziert werden kann.

Bei einer weiteren beispielhaften Ausführungsform des Prüfadapters erstreckt sich der Fluidkanal durch das Koppelelement hindurch. Beispielsweise kann sich der Fluidkanal vom Dichtkörper, über die Dichtseite des Koppelelements, in das Koppelelement hinein erstrecken. Zusätzlich kann der Fluidkanal an der Anschlussseite des Koppelelements eine Mündungsöffnung aufweisen, also an der Anschlussseite des Koppelelements münden. Das Koppelelement und/oder der Fluidkanal kann/können auf der Anschlussseite derart ausgebildet sein, dass ein Fluid aus dem Fluidkanal herausströmen kann. Vorzugsweise ist/sind das Koppelelement und/oder der Fluidkanal so ausgebildet, dass das Fluid aus dem Fluidkanal ausströmen und in den Hochvoltkabelstrang, beispielsweise in das Hochvoltsteckergehäuse des Hochvoltkabelstrangs, einströmen kann. Dies kann insbesondere dann der Fall sein, wenn das Koppelelement abdichtend mit dem Hochvoltkabelstrang, insbesondere dem Hochvoltsteckergehäuse des Hochvoltkabelstrangs, verbunden ist.

Eine Ausführungsform, bei der sich der Fluidkanal durch das Koppelelement hindurch erstreckt, kann vorteilhafterweise bewirken, dass mittels des Prüfadapters die Dichtheitsprüfung zuverlässig durchgeführt werden kann, selbst wenn zeitgleich eine elektrische Prüfung ausgeführt wird. Dies hat den Vorteil, dass durch den Prüfadapter die Gesamtprüfdauer für den Hochvoltkabelstrang reduziert werden kann.

Bevorzugt dichtet der Dichtkörper das Koppelelement an der Dichtseite gegenüber der Umgebung ab. Das heißt, dass ein Fluid, welches sich beispielsweise zwischen dem Koppelelement und dem Hochvoltkabelstrang befindet, nicht über etwaige Spaltmaße und/oder sonstige Kavitäten im Koppelelement entweichen kann. Beispielsweise kann es zwischen den elektrischen Leitern und dem Koppelelement und/oder zwischen dem Fluidkanal und dem Koppelelement herstellungsbedingte Spaltmaße geben, über welche das Fluid von der Anschlussseite zur Dichtseite strömen kann. Aufgrund des Dichtkörpers kann das Fluid auf der Dichtseite jedoch nicht austreten. Der Dichtkörper kann folglich nicht nur die Dichtigkeit der elektrischen Leitungen und des Fluidkanals erhöhen, sondern auch die Dichtigkeit des Koppelelements.

Eine derartige Ausführungsform des Prüfadapters kann vorteilhafterweise bewirken, dass der Prüfadapter besonders fluiddicht ausgebildet ist. Dementsprechend kann mittels des Prüfadapters die Dichtheitsprüfung zuverlässig durchgeführt werden, selbst wenn zeitgleich eine elektrische Prüfung ausgeführt wird. Dies hat den Vorteil, dass durch den Prüfadapter die Gesamtprüfdauer für den Hochvoltkabelstrang reduziert werden kann.

Vorzugsweise weist der Dichtkörper ein Material auf, dass aus Silikon, insbesondere einem Silikonelastomer, besteht. Vorzugsweise besteht der gesamte Dichtkörper vollständig aus Silikon, insbesondere Silikonelastomer. Der Dichtkörper kann einstückig ausgebildet sein, insbesondere in einem Guss hergestellt sein. Ein Dichtkörper aus Silikon hat den Vorteil, dass der Dichtkörper einfach hergestellt werden kann und insofern auch die Herstellungskosten des Prüfadapters weiter reduziert werden können.

Die eingangs genannte Aufgabe der vorliegenden Erfindung wird auch durch ein Prüfsystem gelöst, das einen Prüfadapter gemäß den vorgenannten Ausführungen aufweist. Dementsprechend können sämtliche der vorgenannten Weiterbildungen, Ausführungsformen und/oder Merkmalskombinationen bezüglich des Prüfadapters, sowie die jeweiligen Vorteile in analoger Weise auch auf das Prüfsystem zutreffen.

Das erfindungsgemäße Prüfsystem weist zusätzlich zum Prüfadapter eine elektrische Prüfeinrichtung, insbesondere eine Hochvoltprüfeinrichtung, auf. Die elektrische Prüfeinrichtung ist mit den zumindest zwei elektrischen Leitern elektrisch verbunden. Vorzugsweise ist die elektrische Prüfeinrichtung dazu ausgebildet, die elektrische Prüfung des Hochvoltkabelstrangs auszuführen.

Erfindungsgemäß umfasst das Prüfsystem auch eine Dichtheitsprüfeinrichtung. Die Dichtheitsprüfeinrichtung ist mit dem Fluidkanal fluidkommunizierend verbunden. Vorzugsweise ist die Dichtheitsprüfeinrichtung dazu ausgebildet, die Dichtheitsprüfung des Hochvoltkabelstrangs auszuführen.

Aufgrund des Prüfadapters, der elektrischen Prüfeinrichtung und der Dichtheitsprüfeinrichtung ist das Prüfsystem erfindungsgemäß dazu ausgebildet, die elektrische Prüfung und die Dichtheitsprüfung des Hochvoltkabelstrangs parallel, insbesondere zeitgleich, auszuführen. Dies hat den Vorteil, dass die Dauer des gesamten Prüfungsverfahrens durch das erfindungsgemäße Prüfsystem reduziert werden kann.

Es ist auch eine Aufgabe der vorliegenden Erfindung ein kostgünstiges Verfahren zur Herstellung einer Vorrichtung anzugeben, welche die Gesamtdauer der Prüfungen für Hochvoltkabelstränge reduziert.

Diese Aufgabe wird mit einem Verfahren gemäß Anspruch 8 gelöst. Vorteilhafte Weiterbildungen und Ausführungsformen des Verfahrens sind Gegenstand der abhängigen Ansprüche und/oder werden in der nachfolgenden Beschreibung erläutert.

Durch das erfindungsgemäße Verfahren wird die gleiche erfinderische Idee, wie sie auch dem Prüfadapter und dem Prüfsystem zu Grunde liegt, verwirklicht. Insofern kann das erfindungsgemäße Verfahren ein Verfahren zur Herstellung eines der vorgenannten Prüfadapter sein. Sämtliche der vorgenannten Weiterbildungen, Ausführungsformen und/oder Merkmalskombinationen, sowie die jeweiligen Vorteile können in analoger Weise auch auf das Verfahren zutreffen.

Das erfindungsgemäße Verfahren umfasst die nachfolgend erläuterten Verfahrensschritte.

In einem ersten Verfahrensschritt werden zumindest zwei elektrische Leiter an ein Koppelelement angebracht. Vorzugsweise werden die elektrischen Leiter dabei zumindest abschnittsweise in das Koppelelement eingeschoben und/oder durch das Koppelelement hindurch geschoben. Alternativ oder zusätzlich kann ein elektrischer Leiter auf einer Dichtseite des Koppelelements mit einem elektrischen Leiter des Koppelelements elektrisch kontaktiert werden.

Bei einem weiteren Verfahrensschritt wird zumindest ein Fluidschlauch an das Koppelelement angebracht. Vorzugsweise wird der Fluidschlauch dabei zumindest abschnittsweise in das Koppelelement eingeschoben und/oder durch das Koppelelement hindurch geschoben. Alternativ oder zusätzlich kann der Fluidschlauch derart mit der Dichtseite des Koppelelements verbunden werden, dass eine Mündungsöffnung des Fluidschlauchs an einer Öffnung des Koppelelements vorgesehen wird. Bei dem Fluidschlauch kann es sich um einen flexiblen länglichen Hohlkörper handeln. Der Hohlkörper kann einen im Wesentlichen runden Querschnitt aufweisen. Der Fluidschlauch kann einen Fluidkanal bilden.

Die Abfolge der vorgenannten Verfahrensschritte stellt keinesfalls eine zwingend erforderliche chronologische Abfolge dar. Vielmehr können die einzelnen Verfahrensschritte untereinander ausgetauscht werden und/oder zeitgleich ausgeführt werden.

Das Koppelelement wird dann an eine Gussform angebracht. Dabei wird die Gussform vorzugsweise an der Dichtseite des Koppelelements angeordnet. Die Gussform weist eine Ausnehmung auf, durch welche die elektrischen Leiter und der Fluidschlauch hindurchgeführt werden. Vorzugsweise werden die elektrischen Leiter und der Fluidschlauch derart durch die Ausnehmung hindurchgeführt, dass die elektrischen Leiter und der Fluidschlauch jeweils voneinander und jeweils von der Innenwandung der Gussform beabstandet sind.

Erfindungsgemäß wird die Ausnehmung der Gussform dann mit einem Silikon befüllt. Das Silikon kann beim Befüllen einen flüssigen und/oder zähflüssige Aggregatzustand aufweisen. Vorzugsweise handelt es sich bei dem Silikon um ein aushärtbares bzw. ein sich verfestigendes Silikon. Das heißt, dass das flüssige und/oder zähflüssige Silikon in einen kautschukartigen bzw. elastischen Zustand übergehen kann.

Erfindungsgemäß bildet das Silikon an dem Koppelelement, insbesondere an der Dichtseite des Koppelelements einen Dichtkörper aus. Dies ist insbesondere dann der Fall, wenn das flüssige und/oder zähflüssige Silikon in einen kautschukartigen bzw. elastischen Zustand übergegangen ist.

Das erfindungsgemäße Herstellungsverfahren hat den Vorteil, dass ein Prüfadapter, mit dem die elektrische Prüfung und die Dichtheitsprüfung eines Hochvoltkabelstrangs zeitgleich durchgeführt werden können, besonders kostengünstig hergestellt werden kann. Dies ist dadurch bedingt, dass das erfindungsgemäße Herstellungsverfahren nur wenige Verfahrensschritte aufweist und besonders wenig Bauteile benötigt werden.

Bei einer beispielhaften Weiterbildung des erfindungsgemäßen Verfahrens sind die elektrischen Leitern und der Fluidschlauch beim Befüllen der Ausnehmung derart voneinander und von der Innenwandung der Gussform, dass die elektrischen Leitern und der Fluidschlauch vollständig vom Silikon umhüllt werden. Dies hat den Vorteil, dass der Dichtkörper die elektrischen Leiter, den Fluidschlauch und das Koppelelement besonders gut abdichtet.

Gemäß einer weiteren, beispielhaften Ausführungsform des Verfahrens, wird die Gussform nach dem Aushärten des Silikons entfernt. Anschließend wird das Koppelelement an und/oder in einem Prüfadaptergehäuse angeordnet. Dabei kann der Dichtkörper, durch den sich die elektrischen Leitern und der Fluidschlauch hindurch erstrecken, innerhalb des Prüfadaptergehäuse angeordnet werden. Vorzugsweise wird das Koppelelement beim Anordnen mit dem Prüfadaptergehäuse verschraubt. Das Anordnen des Koppelelements an und/oder in einem Prüfadaptergehäuse hat den Vorteil, dass der Prüfadapter mit bestehenden Prüfadaptergehäusen kompatibel ist. Dies kann die Herstellungskosten weiter reduzieren.

### Kurze Beschreibung der Zeichnungen

Die oben beschriebenen, unterschiedlichen und beispielhaften Merkmale können erfindungsgemäß miteinander kombiniert werden, soweit dies technisch sinnvoll und geeignet ist. Dies gilt unabhängig davon, ob die jeweiligen Merkmale als Vorrichtungs- oder als Verfahrensmerkmale offenbart sind. Weitere Merkmale, Vorteile und Ausführungsformen der Erfindung ergeben sich aus der nachfolgenden Figurenbeschreibung, sowie dem in den Figuren dargestellten Ausführungsbeispiel. Es zeigen:
- Fig. 1: eine Schnittdarstellung eines Prüfadapters mit angeschlossenem Hochvoltkabelstrang, und
- Fig. 2: eine Schnittdarstellung des Prüfadapters gemäß Fig.1 ohne den Hochvoltkabelstrang.

### Wege zur Ausführung der Erfindung

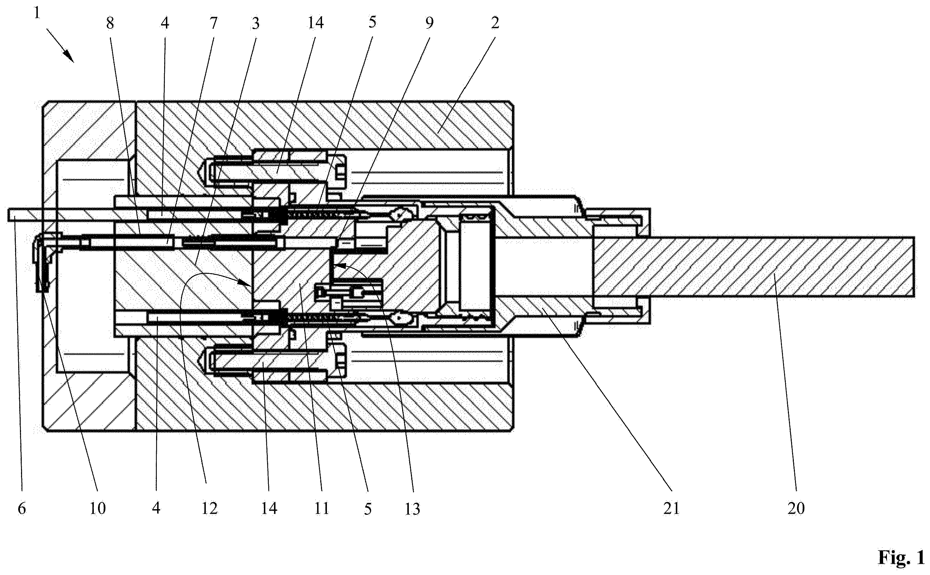

Fig. 1 zeigt eine Schnittdarstellung eines Prüfadapters 1. In den Prüfadapter 1 ist ein Hochvoltkabelstrang 20, insbesondere ein Hochvoltsteckergehäuse 21 des Hochvoltkabelstrangs 20 eingesteckt. Der Prüfadapter 1 ist dazu ausgebildet, den Hochvoltkabelstrang 20 mit einer in Fig. 1 nicht dargestellten elektrischen Prüfeinrichtung, insbesondere einer Hochvoltprüfeinrichtung, und einer Dichtheitsprüfeinrichtung zu verbinden.

Der Prüfadapter 1 umfasst in dem in Fig. 1 dargestellten Ausführungsbeispiel zwei elektrische Leiter 4 und einen Fluidkanal 7. Die elektrischen Leiter 4 und der Fluidkanal 7 erstrecken sich durch einen Dichtkörper 3 hindurch. Der Dichtkörper 3 ist in dem dargestellten Ausführungsbeispiel ein einstückiger Silikonkörper 3.

Die elektrischen Leiter 4 sind jeweils dazu ausgebildet, einen Hochvoltleiter des Hochvoltkabelstrangs 20 mit der elektrischen Prüfeinrichtung zu verbinden. Die elektrischen Leiter 4 umfassen jeweils ein Leiterelement, das einen elektrischen Federkontaktstift 5 mit einem Anschluss 6 für die elektrische Prüfeinrichtung verbindet. Der elektrische Federkontaktstift 5 ist dazu ausgebildet, den entsprechenden Hochvoltleiter des Hochvoltkabelstrangs 20 zu kontaktieren.

Der Fluidkanal 7 weist einen Fluidschlauch 8 auf und ist dazu ausgebildet, eine Mündungsöffnung 9 des Fluidkanals 7 mit einem Anschluss 10 für eine Dichtheitsprüfeinrichtung zu verbinden.

Der Dichtkörper 3 ist so ausgebildet und angeordnet, dass sich die elektrischen Leiter 4 und der Fluidkanal 7 derart durch den Dichtkörper 3 hindurch erstrecken, dass die elektrischen Leiter 4 und der Fluidkanal 7 jeweils gegeneinander und in Bezug auf die Umgebung abgedichtet sind. Das heißt, dass die elektrischen Leiter 4 und der Fluidkanal 7 voneinander beabstandet sind und von dem Silikon des Dichtkörpers 3 umhüllt sind.

Der Prüfadapter 1 umfasst ferner ein Koppelelement 11. Das Koppelelement 11 ist in der Darstellung von Fig. 1 zwischen dem Dichtkörper 3 und dem Hochvoltsteckergehäuse 21 des Hochvoltkabelstrangs 20 angeordnet. Das Koppelelement 11 weist eine Dichtseite 12 und eine der Dichtseite 12 gegenüberliegende Anschlussseite 13 auf. Mit anderen Worten ist die Dichtseite 12 des Koppelelements 11 dem Dichtkörper 3 zugewandt. Die Anschlussseite 13 des Koppelelements 11 ist dem Hochvoltsteckergehäuse 21 des Hochvoltkabelstrangs 20 zugewandt. Das Koppelelement 11 ist in dem in Fig. 1 dargestellten Ausführungsbeispiel als einstückiges Gussbauteil ausgebildet. Das Koppelelement 11 ist über zwei Schraubverbindungen 14 mit einem Prüfadaptergehäuse 2 des Prüfadapters 1 kraftschlüssig verbunden.

Das Koppelelement 11 ist dazu ausgebildet, über seine Anschlussseite 13 abdichtend, insbesondere fluiddicht, mit dem Hochvoltsteckergehäuse 21 des Hochvoltkabelstrangs 20 verbunden zu werden. In dem in Fig. 1 dargestellten Ausführungsbeispiel kann der Hochvoltkabelstrang 20 mit seinem Hochvoltsteckergehäuse 21 auf die Anschlussseite 13 des Koppelelements 11 aufgeschoben werden. Wenn das Hochvoltsteckergehäuse 21 des Hochvoltkabelstrangs 20 auf die Anschlussseite 13 des Koppelelements 11 aufgeschoben ist (Zustand, wie in Fig. 1 gezeigt), kontaktieren die elektrischen Federkontaktstifte 5 der elektrischen Leiter 4 jeweils einen Hochvoltleiter des Hochvoltsteckergehäuses 21. Zwischen der Mündungsöffnung 9 des Fluidkanals 7 und dem Hochvoltsteckergehäuse 21 des Hochvoltkabelstrangs 20 bildet sich ein minimaler Hohlraum aus, welcher über den Fluidkanal 7 mit einem Fluid, insbesondere Druckluft, gefüllt werden kann. Mit anderen Worten ist das Koppelelement 11 an der Anschlussseite 13 derart ausgebildet, dass das Fluid im Fluidkanal 7 über die Mündungsöffnung 9 in den Hochvoltkabelstrang 20, insbesondere in das Hochvoltsteckergehäuse 21 des Hochvoltkabelstrangs 20, einströmen kann.

In dem in Fig. 3 dargestellten Ausführungsbeispiel ist der Dichtkörper 3 an die Dichtseite 12 des Koppelelements 11 angegossen. Die zwei elektrischen Leiter 4 und der Fluidkanal 7 erstrecken sich ausgehend vom Dichtkörper 3 über die Dichtseite 12 des Koppelelements 11 in das Koppelelement 11 hinein und durch das Koppelelement 11 hindurch. Dementsprechend dichtet der Dichtkörper 3 nicht nur die elektrischen Leiter 4 und den Fluidkanal 7 jeweils gegeneinander und in Bezug auf die Umgebung ab, sondern auch das Koppelelement 11. Der Dichtkörper 3 dichtet das Koppelelement 11 insbesondere an seiner Dichtseite 12 ab. Auch die Übergänge der elektrischen Leiter 4 und des Fluidkanals 7 vom Dichtkörper 3 zum Koppelelement 11 an der Dichtseite 12 werden durch den Dichtkörper 3 abgedichtet.

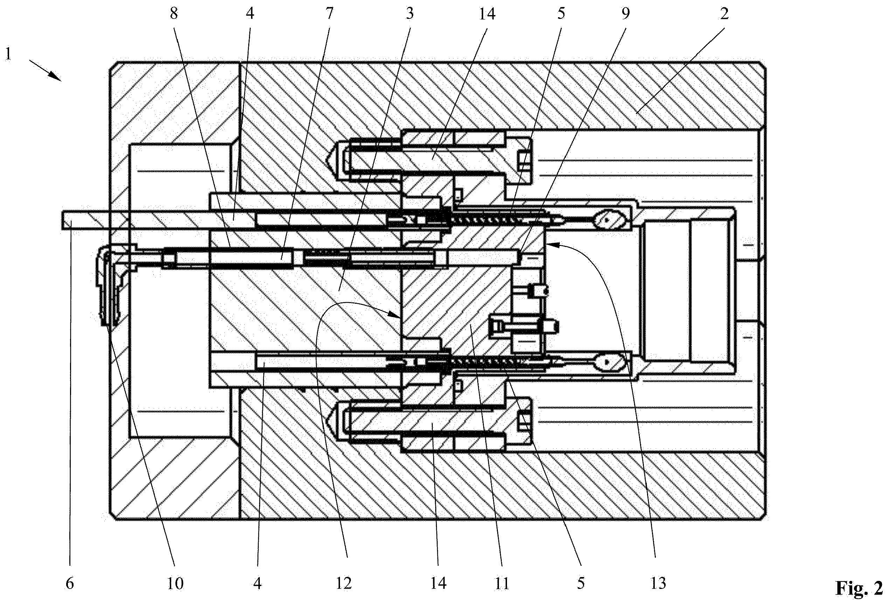

Fig. 2 zeigt den Prüfadapter 1 gemäß Fig. 1 in einer vergrößerten Darstellung, wobei der Hochvoltkabelstrang 20 entfernt wurde.

Zur Herstellung des Prüfadapters 1 wird zunächst das Koppelelement 11 hergestellt. Hierzu wird die Anschlussseite 13 des Koppelelements 11 an den zu überprüfenden Hochvoltkabelstrang 20, insbesondere an das Hochvoltsteckergehäuse 21 des zu überprüfenden Hochvoltkabelstrangs 20, angepasst. Anschließend werden Durchgangsbohrungen für die elektrischen Leiter 4 und den Fluidkanal 7 vorgesehen.

Danach werden über die Dichtseite 12 des Koppelelements 11 die elektrischen Leiter 4 und der Fluidschlauch 8, welcher später den Fluidkanal 7 ausbildet, an das Koppelelement 11 angebracht. Dabei können die elektrischen Leiter 4 und der Fluidschlauch 8 in das Koppelelement 11, insbesondere in die Durchgangsbohrungen, eingeführt werden. Anschließend kann das Koppelelement 11 mit den elektrischen Leitern 4 und dem Fluidschlauch 8 an eine in den Figuren nicht gezeigte Gussform angebracht werden. Die Gussform weist eine Ausnehmung auf, durch welche die elektrischen Leiter 4 und der Fluidschlauch 8 hindurchgeführt werden. Beim Hindurchführen ist darauf zu achten, dass die elektrischen Leiter 4 und der Fluidschlauch 8 jeweils voneinander und von der Innenwandung der Gussform, welche die Ausnehmungen bildet, beabstandet sind. Anschließend wird die Ausnehmung mit aushärtbaren Silikon gefüllt, sodass die elektrischen Leiter 4 und der Fluidschlauch 8 im Bereich der Ausnehmung vollständig vom Silikon umhüllt werden und der Dichtkörper 3 an der Dichtseite 12 des Koppelelements 11 ausgebildet wird.

Sobald das Silikon hinreichend ausgehärter ist, kann die Gussform entfernt werden. Das Koppelelement 11 kann dann gemeinsam mit dem Dichtkörper 3 und den sich durch den Dichtkörper 3 hindurch erstreckenden elektrischen Leitern 4 und dem Fluidschlauch 8 in das Prüfadaptergehäuse 2 eingebracht werden. Zusätzlich kann das Koppelelement 11 mit dem Prüfadaptergehäuse 2 verschraubt werden.

Bei alternativen Ausführungsbeispielen ist es auch denkbar, dass auf ein Prüfadaptergehäuse 2 verzichtet wird, und der Prüfadapter 1 bereits nach entfernen der Gussform fertiggestellt ist.

Ein in den Figuren nicht dargestelltes Prüfsystem umfasst neben dem Prüfadapter 1 auch noch eine elektrische Prüfeinrichtung, insbesondere eine Hochvoltprüfeinrichtung, und eine Dichtheitsprüfeinrichtung.

Die elektrische Prüfeinrichtung ist an die Anschlüsse 6 der elektrischen Leiter 4 angeschlossen. Mit der elektrischen Prüfeinrichtung können die Hochvoltleiter des Hochvoltkabelstrangs 20 elektrisch getestet werden. Diese Tests können insbesondere Kurzschlussteste und elektrische Widerstandsteste umfassen.

Die Dichtheitsprüfeinrichtung ist über den Anschluss 10 mit dem Fluidkanal 7 verbunden. Mit der Dichtheitsprüfeinrichtung kann der Hochvoltkabelstrang 20 auf Dichtheit geprüft werden. Hierzu wird so lange Druckluft über den Fluidkanal 7 und über dessen Mündungsöffnung 9 in den Hochvoltkabelstrang 20 eingeleitet, bis ein Überdruck von 0,2 bar anliegt. Anschließend wird über den Fluidkanal 7 und über dessen Mündungsöffnung 9 so viel Druckluft von der Dichtheitsprüfeinrichtung nachgeführt, dass der Überdruck von 0,2 bar konstant bleibt. Anhand der nachgeführten Druckluft kann dann die Leckrate des Hochvoltkabelstrangs 20 bestimmt werden.

### BEZUGSZEICHENLISTE

- 1: Prüfadapter
- 2: Prüfadaptergehäuse
- 3: Dichtkörper
- 4: elektrischer Leiter
- 5: Federkontaktstift
- 6: Anschluss für elektrische Prüfeinrichtung
- 7: Fluidkanal
- 8: Fluidschlauch
- 9: Mündungsöffnung
- 10: Anschluss für Dichtheitsprüfeinrichtung
- 11: Koppelelement
- 12: Dichtseite
- 13: Anschlussseite
- 14: Schraubverbindung

- 20: Hochvoltkabelstrang
- 21: Hochvoltsteckergehäuse

## Patentansprüche

1. Prüfadapter (1) für einen Hochvoltkabelstrang (20), der Prüfadapter (1) umfassend:
- zumindest zwei elektrische Leiter (4), die jeweils dazu ausgebildet sind, ein Hochvoltleiter des Hochvoltkabelstrangs (20) mit einer elektrischen Prüfeinrichtung zu verbinden,
- zumindest einen Fluidkanal (7), der dazu ausgebildet ist, mit einer Dichtheitsprüfeinrichtung fluidkommunizierend verbunden zu werden, und
- einen Dichtkörper (3), wobei
- sich die elektrischen Leiter (4) und der Fluidkanal (7) derart durch den Dichtkörper (3) hindurch erstrecken, dass die elektrischen Leiter (4) und der Fluidkanal (7) durch den Dichtkörper (3) jeweils gegeneinander und in Bezug auf die Umgebung abgedichtet werden.

2. Prüfadapter (1) nach Anspruch 1, **dadurch gekennzeichnet, dass** der Prüfadapter (1) ein Koppelelement (11) umfasst, wobei das Koppelelement (11) eine Dichtseite (12) aufweist, die mit dem Dichtkörper (3) verbunden ist, und das Koppelelement (11) eine Anschlussseite (13) aufweist, über die das Koppelelement (11) abdichtend mit dem Hochvoltkabelstrang (20) verbindbar ist.

3. Prüfadapter (1) nach Anspruch 2, **dadurch gekennzeichnet, dass** das Koppelelement (11) einstückig ausgebildet ist und/oder mit einem Prüfadaptergehäuse (2) des Prüfadapters (1) kraftschlüssig verbindbar ist.

4. Prüfadapter (1) nach einem der Ansprüche 2 oder 3, **dadurch gekennzeichnet, dass** der Dichtkörper (3) an die Dichtseite (12) des Koppelelements (11) angegossen ist.

5. Prüfadapter (1) nach einem der Ansprüche 2 bis 4, **dadurch gekennzeichnet, dass** sich der zumindest eine Fluidkanal (7) durch das Koppelelement (11) hindurch erstreckt und an der Anschlussseite (13) des Koppelelements (11) mündet, wobei das Koppelelement (11) an der Anschlussseite (13) derart ausgebildet ist, dass ein Fluid aus dem Fluidkanal (7) herausströmen kann.

6. Prüfadapter (1) nach einem der Ansprüche 2 bis 5, **dadurch gekennzeichnet, dass** der Dichtkörper (3) das Koppelelement (11) an der Dichtseite (12) des Koppelelements (11) gegenüber der Umgebung abdichtet.

7. Prüfsystem für einen Hochvoltkabelstrang (20), das Prüfsystem umfassend:
- einen Prüfadapter (1) nach einem der Ansprüche 1 bis 6,
- eine elektrische Prüfeinrichtung, die mit den zumindest zwei elektrischen Leitern (4) elektrisch verbunden ist, und
- eine Dichtheitsprüfeinrichtung, die mit dem zumindest einen Fluidkanal (7) fluidkommunizierend verbunden ist, wobei
- das Prüfsystem dazu ausgebildet ist, eine elektrische Prüfung und eine Dichtheitsprüfung des Hochvoltkabelstrangs (20) zeitgleich auszuführen.

8. Verfahren zur Herstellung eines Prüfadapters (1), das Verfahren umfassend die folgenden Verfahrensschritte:
- Anbringen von zumindest zwei elektrischen Leitern (4) an einem Koppelelement (11),
- Anbringen von zumindest einem Fluidschlauch (8) an dem Koppelelement (11),
- Anbringen des Koppelelements (11) an eine Gussform, wobei sich die zumindest zwei elektrischen Leiter (4) und der zumindest eine Fluidschlauch (8) durch eine Ausnehmung der Gussform hindurch erstrecken,
- Befüllen der Ausnehmung der Gussform mit einem aushärtbaren Silikon, um an dem Koppelelement (11) einen Dichtkörper (3) aus Silikon auszubilden.

9. Verfahren nach Anspruch 8, **dadurch gekennzeichnet, dass** die elektrischen Leitern (4) und der Fluidschlauch (8) beim Befüllen der Ausnehmung voneinander und von einer Innenwandung der Gussform, welche die Ausnehmung begrenzt, beabstandet sind, so dass die elektrischen Leitern (4) und der Fluidschlauch (8) im Bereich der Ausnehmung vollständig vom Silikon umhüllt werden.

10. Verfahren nach einem der Ansprüche 8 oder 9, **dadurch gekennzeichnet, dass** die Gussform nach dem Aushärten des Silikons entfernt wird und das Koppelelement (11) gemeinsam mit dem Dichtkörper (3), den sich durch den Dichtkörper (3) hindurch erstreckenden elektrischen Leitern (4) und dem sich durch den Dichtkörper (3) hindurch erstreckenden Fluidschlauch (8) in einem Prüfadaptergehäuse (2) angeordnet wird.
